# EUROPÄISCHE PATENTSCHRIFT

(11) **EP 3 900 010 B1**
(45) Veröffentlichungstag und Bekanntmachung des Hinweises auf die Patenterteilung: **04.09.2024**
(21) Anmeldenummer: 19817244.7
(22) Anmeldetag: 05.12.2019
(51) Int. Cl.: H01J 37/32, H01J 37/34, C23C 14/32

(54) **ELEKTRODENANORDNUNG FÜR EINE PLASMAQUELLE ZUR DURCHFÜHRUNG VON PLASMABEHANDLUNGEN**
ELECTRODE ARRANGEMENT FOR A PLASMA SOURCE FOR CARRYING OUT PLASMA TREATMENTS
AGENCEMENT D'ÉLECTRODES POUR UNE SOURCE DE PLASMA POUR EXÉCUTER DES TRAITEMENTS DE PLASMA

(30) Priorität: 21.12.2018 US 201862783498 P; 26.02.2019 CH 2352019
(43) Veröffentlichungstag der Anmeldung: 27.10.2021
(73) Patentinhaber: Oerlikon Surface Solutions AG, Pfäffikon, 8808 Pfäffikon (CH)
(72) Erfinder: VETTER, Jörg, 51429 Bergisch Gladbach (DE)
(74) Vertreter: IPS Irsch AG
(86) Internationale Anmeldenummer: PCT/EP2019/083897
(87) Internationale Veröffentlichungsnummer: WO 2020/126530

(56) Entgegenhaltungen:
- WO-A2-2006/099758
- DE-C1- 4 125 365
- DE-C1- 4 203 371
- US-A1- 2004 055 538

## Beschreibung

### TECHNISCHES GEBIET

Die vorliegende Erfindung betrifft ganz allgemein eine Vakuumkammer mit mindestens einer Plasmaquelle und im Speziellen eine Vakuumkammer mit einer Plasmaquelle zur Generierung eines Plasmas zur Durchführung von Plasmabehandlungen auf Oberflächen von Substraten, die innerhalb der Plasmakammer angeordnet sind, wobei eine spezielle Elektrodenanordnung eine erhöhte Effizienz der Plasmabehandlung erlaubt.

### HINTERGRUND

Zur Plasmaerzeugung kann zum einen die elektrische Glimmentladung, die auf den Durchgang eines Stromes durch ein Gas durch das Anlegen einer hinreichend hohen Spannung zwischen einer Kathode und einer Anode, wie zum Beispiel Argon oder ein anderes Edelgas bei definierten niedrigen Drücken gebildet wird, eingesetzt werden. Zum anderen kann die Plasmaerzeugung des Gases oder Gasgemisches in Form eines Niederdruckplasmas durch die Wechselwirkung hochenergetischer Elektronen mit Gasen erfolgen, die durch eine Elektronenquelle bereitgestellt werden und durch geeignete Elektroden auf definierte Energien beschleunigt werden, genutzt werden. Eine solche Elektronenquelle kann beispielsweise ein kathodischer Vakuumbogenverdampfer bestehend aus einer geeignet abgeschirmten Bogenkathode und einer die Bogenelektronen aufnehmende Bogenanode sein. Zur Gasplasmaerzeugung werden diese Bogenelektronen mit geeigneten Elektroden abgesogen und dabei hochenergetisch beschleunigt. Das dadurch erzeugte Gasplasma kann für unterschiedliche Plasmabehandlungen von Substraten genutzt werden. Beispielsweise dienen dadurch erzeugte Inertgasionen (z.B.) Argonionen einer lonenreinigung der Substrate. Im Plasma angeregte, gegebenenfalls zerlegte chemische Verbindungen sowie atomisierte Moleküle der Gase und Gasgemische können zur thermochemischen Behadlung von Substraten oder gar zur Schichtabscheidung eingestzt werden. Dabei gilt es, die lokale Plasmaerzeugung definiert hinsichtlich der Behandlungsziele mit geeigneten Elektroden in Form, Anordung und Betriebsparametern einzustellen.

Ein Ziel ist dabei die Elektroden so auszuführen, dass diese nicht störend in den Behandlungsraum ragen, mit hohen Leistungsdichten beaufschlagbar sind und möglichst einfach zu warten sind. Beispiele von bekannten Vakuumbogenverdampfungssystemen sind aus US 2004/055538 A1, DE 42 03 371 C1, DE 41 25 365 C1, und WO 2006/099758 A2 bekannt.

### BESCHREIBUNG DER VORLIEGENDEN ERFINDUNG

Die Erfindung betrifft eine Vakuumkammer zur Durchführung einer Plasmabehandlung mit einem Plasmabehandlungsbereich, der von Kammerwänden umschlossen ist, sowie eine Plasmaquelle. Hierbei umfasst die Plasmaquelle eine Kathode zur kathodischen Vakuumbogenverdampfung mit einer Bogenanode die mit der Kammer verbunden ist, wobei die Kathode in der Kammer an der Kammerwand angeordnet ist, eine Abschirmung zur Abschirmung von Partikeln und Metallionen, die von der Kathode emittiert werden, wobei die Abschirmung derart an der Kammerwand vorgesehen ist, dass sie vor der Katode angeordnet werden kann und eine von der Kathode beabstandete, in der Kammer angeordnete, Elektrode. Die Elektrode umfasst hierbei eine zweidimensionale Oberfläche zum Auffangen der von der Kathode emittierten Elektronen. Die zweidimensionale Oberfläche hat eine zu einer Oberflächennormale erste orthogonale Ausdehnung und eine zweite orthogonale Ausdehnung, wobei die erste orthogonale Ausdehnung senkrecht zu der zweiten orthogonalen Ausdehnung verläuft, und ein Längenverhältnis der ersten orthogonalen Ausdehnung zu der zweiten orthogonalen Ausdehnung zwischen 0,4 und 1 liegt. Die erfindungsgemässe Elektrode kann insbesondere zumindest zeitweise mittels eines geeigneten Stromversorgungsgerätes anodisch geschlatet sein.

Im Folgenden werden einleitend in vereinfachter Form einige Konzepte vorgestellt, die später noch detaillierter ausgeführt werden.

Die erfindungsgemässe Vakuumkammer kann insbesondere dazu verwendet werden eine lokal einstellbare Behandlung von Substarten zu ermöglichen und zu verbessern, sowie eine Plasmaverteilung der Vakuumkammer zu steuern.

Eine Elektronquelle der Plasmaquelle kann eine Bogenkathode eines Bogenverdampfers mit geeigneter Abschirmung sein, welche mit einem Bogennetzteil verbunden ist. Der positive Pol des Bogennetzteiles kann dabei als eine erfindungsgemässe Bogenanode einfacher Weise mit der Kammerwand verbunden sein. Die Bogenelektronen-fangende Elektrode wird mit einem positiven Pol eines weiteren Netzteils verbunden und ist folglich eine elektronen-aufnehmende Elektrode. Diese Elektrode wird verwendet um Bogenelektronen in Richtung dieser Elektrode zu beschleunigen. Diese beschleunigten Elektronen regen ein Gasplasma an und werden auf der im Wesentlichen zweidimensioanle Oberfläche der Elektrode aufgefangen. Es können typische industrielle kathodische Vakuumbogenverdampfer als Elekotronenquellen verwendet werden.

Je nach Betriebsmodus können das Netzteil der Kathode und das Netzteil der Elektrode umgeschaltet und geregelt werden. Die erfindungsgemässe Elektrode kann sowohl als Anode als auch als Beschichtungsquelle (kathodischer Vakuumbogenverdampfer, Sputterquelle; also als ein Target) betrieben werden. Hierfür wird das Netzteil für einen Betrieb als Beschichtungsquelle negativ vorgespannt und für einen Betrieb als Anode postiv vorgespannt.

Vor dem kathodischen Vakuumbogenverdampfer, der als Elektronenquelle verwendet werden kann, ist vorzugsweise eine Abschirmung vorgesehen, die derart ausgestaltet ist, dass sie dem Wärmeeintrag durch die Vakuumbogenverdampfung standhält. Die Dimsionierung einer Fläche einer solchen Abschirmung sollte grösser sein als die gesamte Fläche der kathodischer Vakuumbogenverdampfer, welche die zu verdampfende Oberfläche umfasst, um eine Bedampfung der Substrate zu vermeiden.

In Ausführung der Erfindung können eine oder mehrere Elektronen sammelnde Elektroden in Form von ungekühlten Elektroden in die Behandlungskammer eingebracht werden. Die Verwendung von ungekühlten Elektroden kann jedoch zu einer Limitierung der Leistung führen, mit welcher die Elektroden beaufschlagt werden können. Daher werden vorteilhaft gekühlte Elektroden, zum Beispiel wassergekühlte Elektroden verwendet. Hierbei ist vorzugseweise der die Arbeitsoberfläche bildende Teil der Elekrode gekühlt.

Als Energieversorgung für die Elektroden können eine oder mehrere typische Netzteile (also Stromquellen) verwendet werden, die eine Spannung von bis zu 100 V und einen Strom von bis zu 400 A liefern können. Hierbei können an den Elektroden Stromdichten zwischen 0,1 bis 5 A/cm² und Leistungsdichten zwischen 0,5 bis 500 W/cm² erreicht werden.

In der Kammer sollte ein totaler Gasdruck in einem Bereich von 0,01 Pa bis 10 Pa während der Plasmabehandlung aufrechterhalten werden, bevorzugt ein Gasdruck im Bereich von 0,1 Pa bis 2 Pa. Typische Gase sind dabei Argon, Wasserstoff, Stickstoff oder Kohlenwasserstoffgase (z.B. C₂H₂, Acetylen), die je nach Behandlungsziel als reine Gase oder Gasmischungen eingesetzt werden.

Die erfindungsgemässe Vakuumkammer kann sowohl eine Vielzahl von Elektroden, als auch eine Vielzahl von Kathoden, insbesondere kathodischen Vakuumbogenverdampfern, umfassen. Hierbei können mehrere Kathoden, insbesondere kathodische Vakuumbogenverdampfer, eine einzige Abschirmung oder mehere Abschirmungen besitzen. Mehrere Kathoden, insbesondere kathodische Vakuumbogenverdampfer, mit der einen Abschirmung können dabei vorteilhaft mit mindestens einer Elektrode in der Vakuumkammer angeordnet sein. Inbesondere kann in der Vakuumkammer auch eine gleiche Anzahl von Elektroden und Kathoden (insbesondere kathodischen Vakuumbogenverdampfern), mehr Elektroden als Kathoden (insbesondere kathodische Vakuumbogenverdampfer), oder mehr Kathoden (insbesondere kathodische Vakuumbogenverdampfer) als Elektroden umfassen. Die Elektroden und Kathoden können hierbei an verschiedenen Stellen in der Vakuumkammer (Wände, Decke, Boden) angeordnet sein. Sowohl über die Anordnung als auch über die Anzahl der Elektroden und Kathoden (insbesondere kathodischen Vakuumbogenverdampfer), kann die Plasmaverteilung in der Vakuumkammer eingestellt werden. Ausserdem kann so zum Beispiel in einem lonenätzprozess eine Verbesserung der Ätztiefe und / oder der Ätzhomogenität an einem Substrat erreicht werden. Die Verwendung von mehr als einer Elektrode erlaubt den Einsatz von verschiedenen Strömen an den Elektroden sowie eine Zeit selektive Anwendung der Ströme, sodass seine verbesserte Kontrolle der Plasmaerzeugung ermöglicht wird.

Der Elektronenstrom an der Elektrode kann durch eine Anpassung der Elektrodenspannung eingestellt werden. Niedrige Elektrodenspannungen resultieren in einem niedrigen Elektronenstrom und einer niedrigen Plasmaaktivität.

Ein typischer maximaler Elektronenstrom an der einen oder den mehreren Elektroden sollte bei ungefähr 120% des Stromes des kathodischen Vakuumbogenverdampfers (Bogenstrom) gewählt werden. Zum Beispiel: Wenn in einer Vakuumkammer, die Argon bei einem Argon Druck on 0,5 Pa enhält, ein kathodischer Vakuumbogenverdampfer als Elektronenquelle verwendet wird, wobei der kathodische Vakuumbogenverdampfer bei einem Bogenstrom von 100 A betrieben wird, sollte der gesamte Elektrodenstrom auf ungefähr 120 A eingestellt werden. Das heisst, dass der Strom an der einen Elektrode, beziehungsweise wenn mehr als eine Elektrode verwendet wird, die Summe der einzelnen Ströme an den einzelnen Elektroden, auf 120 A eingestellt werden sollte.

Wenn die Vielzahl von Elektroden entlang einer (oder mehreren) Kammerwand derart angeordnet sind, dass sie über die Höhe der Vakuumkammer verteilt sind, kann jede Elektrode an einem separaten Netzteil oder an einer bestimmten Gruppe von Netzteilen betrieben werden, so dass die Elektrode umgeschaltet werden können, um sie mit einem maximalem bzw. behandlungsabhängigen optimierten Strom zu betreiben oder um sie parallel mit einem maximalen Strom zu betreiben, indem verschiedene Spannungen an die verschiedenen Elektrode angelegt werden. Typische Werte von Elektrodenspannung liegen im Bereich von 10 V - 50 V und typische Elektrodenströme liegen im Bereich von 10 A - 200 A. Zur Regelung der lokalen Plasmadichten werden diese mit unterschiedlichen Stömen betrieben. Dies kann der Einstellung eines homogenen Behandlungszieles, z.B. einer Ionenreinigung dienen.

Wenn der Kammer eine Mischung eines Argon Gasflusses und eines Wasserstoff Gasflusses zur Erzeugung eines Plasmas in der Kammer zugeführt wird, welches Plasma durch eine oder mehrere Elektronenquellen und eine oder mehrere Elektroden mit zweidimensionalen Oberflächen zur Aufnahme der von der Kathode emittierten Elektronen erzeugt wird, kann ein so erzeugtes Plasma als Plasma zur Ionenreinigung der dem Plasma ausgesetzten Oberflächen verwendet werden. Wenn in die Kammer zusätzlich ein Sticktoff Gasfluss eingeleitet wird, kann eine thermochemische Wärmebehandlung, die umgangssprachlich als Nitrierung bezeichnet wird, in den von dem so erzeugten Plasma ausgesetzten Oberflächen erfolgen.

Die vorliegende Erfindung kann ausserdem zur Durchführung von Beschichtungsprozessen verwendet werden, zum Beispiel zum Aufbringen von Diamantähnlichen Kohlenstoff (DLC) Schichten. Im Fall, dass eine DLC Schicht vom Typ a-C:H aufgebracht werden soll, sollte der Kammer eine Mischung aus einem Acetylen (C₂H₂) Gasfluss und einem Argon Gasfluss zugeführt werden.

Praktisch jede Beschichtungsvorrichtung, die für die Durchführung von Vakuumbeschichtungsprozessen ausgelegt ist, wie z.B. PVD-Bogenverdampfungsprozesse oder PVD-Sputterprozesse, einschliesslich HiPIMS, oder plasmaunterstützte chemische Abscheidungsprozesse (PA-CVD), kann für die Durchführung von Plasmabehandlungsprozessen gemäss der vorliegenden Erfindung angepasst werden.

Bei der erfindungsgemässen Anordung ist die elektronenbeschleuningende Elektrode nicht räumlich linear im Sinne eines Verhältnisses zwischen der Länge der Elektrode und der Querschnitte, die häufig rechteckig bzw. kreisförmig oder elliptischen sind. Es werden im Wesentlichen zweidimensionale Elektroden verwendet. D.h. die zweidimensionale Oberfläche hat die zu der Oberflächennormale erste orthogonale Ausdehnung und die zweite orthogonale Ausdehnung, wobei die erste orthogonale Ausdehnung senkrecht zu der zweiten orthogonalen Ausdehnung verläuft. Das Längenverhältnis der ersten orthogonalen Ausdehnung zu der zweiten orthogonalen Ausdehnung liegt zwischen 0,4 und 1. Die zweidimensionale Oberfläche kann dabei kreisförmig, ellipsoidisch aber auch rechteckig sein oder andere geeignete Formen aufweisen. Ist die zweidimensionale Oberfläche kreisförmig entsprechen die erste orthogonale Ausdehnung und die zweite orthogonale Ausdehnung insbesondere dem Durchmesser der zweidimensionalen Oberfläche. Ist die zweidimensionale Oberfläche rechteckig entspricht die erste orthogonale Ausdehnung einer ersten Kantenlänge und die zweite orthogonale Ausdehnung einer zweiten Kantenlänge der zweidimensionalen Oberfläche. Ist die zweidimensionale Oberfläche ellipsoidisch entsprechen die erste orthogonale Ausdehnung und die zweite orthogonale Ausdehnung insbesondere Abständen von gegenüberliegenden Scheitelpunkten der zweidimensionalen Oberfläche. Zweidimensional nimmt unter anderen auch darauf Bezug, dass die Elektronen auf eine im Wesentlichen planare Fläche treffen. Die Fläche selbst kann jedoch durch die Herstellung oder Verwendung bedingt eine gewisse Strukturieung aufweisen. Diese Strukturierung kann durch Erosion der Elekotrde bei einer Verwendung als Beschichtungsquelle auftreten. Dabei kann durch die Erosion, die Elektrode derart abgetragen werden, dass sie keine glatte beziehungsweise regelmässige Struktur / Rand mehr aufweist. Derart strukturierte und erodierte Elektroden werden im Rahmen der Erfindung auch als im Wesentlichen planar angesehen. Das Verhältnis zwischen einer maximalen Tiefe der Strukturierung und der kleineren orthogonalen Ausdehung (im Bezug auf die erfindungsgemässe erste orthogonale Ausdehnung oder zweite orthogonale Ausdehnung) der zweidimensionalen Oberfläche der Elektrode beträgt maximal 0,4, insbesondere maximal 0,3, im speziellen maximal 0,2. Die maximale Tiefe der Strukturierung sollte also immer kleiner sein, als die kleinere orthogonale Ausdehnung.

Im einfachsten Falle wird eine kreisförmige Elektrode betrieben, die vorzugsweise einen Elektrodendurchmesser von 100 mm besitzt. Hierbei kann die Elektrode, an einer Wand der Vakuumkammer befestigt sein und auch zumindest teilweise in der Kammerwand angeordnet sein. Ist die Elektrode zumindest teilweise in der Kammerwand angeordnet, hat dies den deutlichen Vorteil, dass die Elektrode nicht massgeblich in de Beschichtungsraum hineinragt. Wenn, wie vorrangehend beschreiben, mehrere zwei-dimensionale Elektroden vorliegen, können die Elektroden an unterschiedlichen Kammerwänden befestigt sein. Werden beispielsweise zwei zweidimensionale Elektroden eingebaut, sind die zwei zweidimensionalen Elektroden vorzugsweise an gegenüberliegenden Kammerwänden angeordnet. Selbstverständlich gibt es aber auch die Möglichkeit, dass mehrere zwei-dimensionale Elektroden, an benachbarten und / oder mehrere zwei-dimensionale Elektroden an der gleichen Kammerwand angeordnet sind. Dabei haben eine erste und eine zweite Elektrode vorzugsweise einen Abstand von 20 bis 400 mm, vorzugsweise 200mm, wenn diese an einer Kammerwand übereinander oder nebeneinander betrieben werden.

Die Anordnung der zwei-dimensionalen Elektrode an einer Kammerwand hat dabei insbesondere folgende Vorteile gegenüber dem Stand der Technik mit einer linearen Elektrode innerhalb der Vakuumkammer. Der Plasmabehandlungsbereich innerhalb der Vakuumkammer, insbesondere im Zentrum der Vakuumkammer, bietet mehr freien Raum. Durch diesen freien Raum kann somit eine bessere Nutzung der Kammer erreicht werden. Für eine bessere Nutzung der Kammer können die zu behandelnden Substrate innerhalb der Vakuumkammer besser verteilt werden, da durch den geschaffenen freien Raum in der Kammer mehr Platz zum Verteilen der zu behandelnden Substrate vorliegt. Hierdurch kann auch eine homogene Plasmabehandlung der Substratoberflächen ermöglicht werden, insbesondere wenn die zu behandelnden Substrate gleichmässiger in der Kammer angeordnet werden können. Ein weiterer Vorteil der erfindungsgemässen Anordnung ist, dass eine einfache Kühlung dieser erfindungsgemässen Elektroden ermöglicht wird. Eine zweidimensionale Oberfläche wie sie bei den erfindungsgemässen Elektroden vorliegt, ist selbstverständlich deutlich einfacher und effektiver kühlbar, als es bei einer linearen Elektrode möglich wäre. Die Kühlung der die Elektronen-aufnehmende Fläche kann direkt (wasserangeströmt) oder indirekt sein. Indirekt ist dabei das Klemmen eines geeigneten Elektrodenmaterials auf einen Kühlkörper.

Bei der erfindungsgemässen Vakuumkammer zur Durchführung einer Plasmabehandlung können unter anderem auch ein Magnetsystem verwendet werden. Das Magnetsystem beziehungsweise die Magnetsysteme können dabei zur Einstellung der Verteilung des Plasmas in der Vakuumkammer (Kammer) verwendet werden. Insbesondere kann ein Magnetsystem dazu verwendet werden die Verteilung des Plasmas an den zweidimensionalen Elektrode zu steuern.

Das Material der Kathode der Elektronenquelle auf der Basis eines kathodischen Vakuumbogenverdampfers (später auch einfach als Verdampfer bezeichnet), kann vorzugsweise Titan (Ti), Zirkonium (Zr) oder Aluminium (Al) sein. Auch kann die Kathode aus Titanlegierungen und/oder Zirkoniumlegierungen und/oder Aluminium sowie Aluminiumlegierungen bestehen. Selbstverständlich kann das Material der Kathode auch aus einem anderen geeigneten Element, einer anderen geeigneten Legierung oder einem anderen geeigneten Metall bestehen, welches eine Adsorption von Restgasen in der Vakuumkammer (z.B. Wasser, Sauerstoff), die durch Ausgasungen oder Leckagern bedingt sind, begünstigt. Durch derartige Eigenschaften der Kathode des Vakuumbogenverdampfers, der als Elektronenquelle dient, kann unter anderem auch eine bessere Vakuumqualität für die Durchführung der Plasmaverfahren erreicht werden. Als Elektrodenmaterialien sind alle möglichen aus dem Stand der Technik bekannten Targetmaterialien der kathodischen Vakuumbogenverdampfer geeignet. Hier bei können als Elektrodenmaterial unter anderem Kohlenstofftargets verwendet werden, welche aus reinem Kohlenstoff oder Legierungen wie Kupferkohlenstoffflegierungen. Auch als Elektrodenmaterial geeignet sind Stahl, Kupfer, Kupferlegierungen, Aluminium, Aluminiumlegierungen, oder leitfähige Verdampfermaterialien wie Aluminiumtitan, Chrom oder Vanadium.

In Ausführung der Erfindung kann die erfindungsgemässe Elektrode als Anode (Bogenelektronen aufnehmend) verwendet werden, und kann damit insbesondere zeitweise anodisch geschaltet werden. Ausserdem kann in der erfindungsgemässen Vakuumkammer zusätzlich die zweite Elektrode angeordnet sein und auch eine weitere, von der Kathode beabstandete dritte Elektrode angeordnet sein. Auch kann in der erfindungsgemässen Vakuumkammer die zweite Kathode und eine von der zweiten Kathode beabstandete vierte Elektrode vorgesehen sein, wobei die von der ersten Kathode emittierten Elektronen selektiv in Richtung zur dritten Elektrode fliessen und die von der zweiten Kathode emittierten Elektronen selektiv in Richtung zur vierten Elektrode fliessen.

In der Praxis kann in der Vakuumkammer auch die zweite Kathode angeordnet sein, wobei von der ersten Kathode emittierte Elektronen selektiv zur ersten Elektrode fliessen und von der zweiten Kathode emittierte Elektronen selektiv zur zweiten Elektrode fliessen. In Ausführung der Erfindung umfasst die Vakuumkammer ein erstes Netzteil, das mit der Elektrode verbunden ist. Ausserdem kann die erfindungsgemässe Vakuumkammer ein zweites Netzteil umfassen, das mit der zweiten Elektrode verbunden ist.

Das erste Netzteil kann derart ausgestaltet sein, dass ein erster Strom der ersten Elektrode zuführbar ist und das zweite Netzteil kann derart ausgestaltet sein, dass ein zweiter Strom der zweiten Elektrode zuführbar ist. Hierbei kann der erste Strom verschieden vom zweiten Strom sein und die erste Elektrode kann während eines ersten Zeitintervalls mit dem ersten Strom gespeist werden und die zweite Elektrode während eines zweiten Zeitintervalls mit dem zweiten Strom gespeist werden. Das erste Zeitintervall und das zweite Zeitintervall können überlappen. Ausserdem kann der erste Strom gleich dem zweiten Strom sein, und das erste Zeitintervall verschieden vom zweiten Zeitintervall. Alternativ kann der erste Strom verschieden vom zweiten Strom sein und wobei das erste Zeitintervall gleich dem zweiten Zeitintervall ist.

### BEISPIELE UND BEVORZUGTE AUSFÜHRUNGSBEISPIELE DER VORLIEGENDEN ERFINDUNG

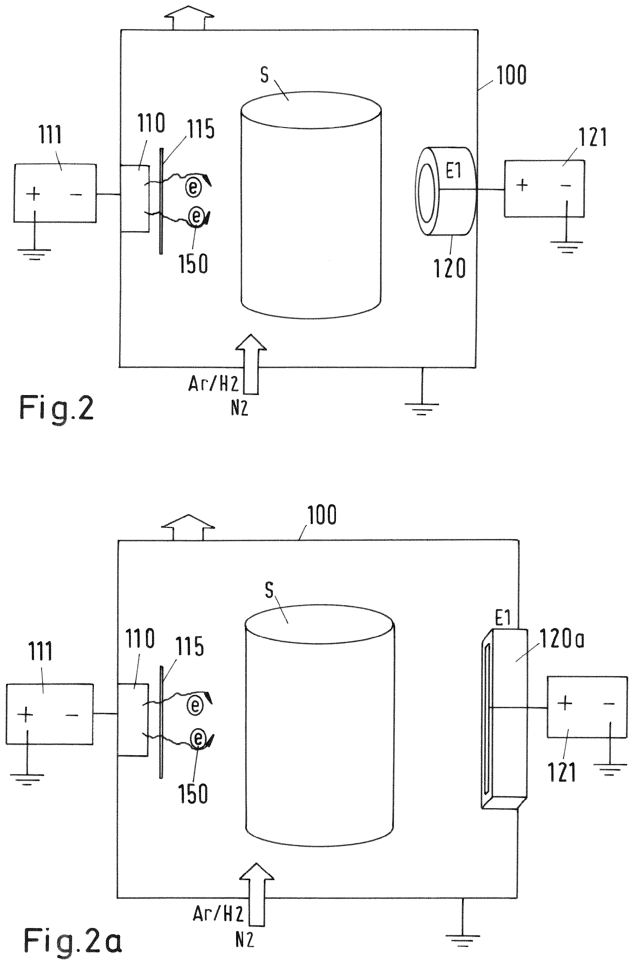

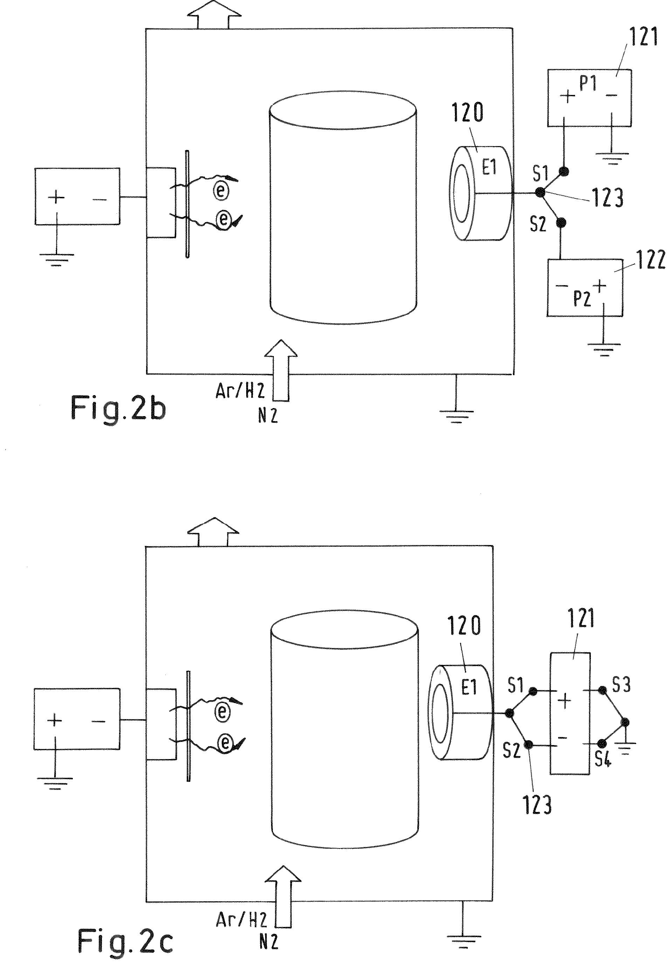

Gemäss einem erfindungsgemässen Ausführungsbeispiel wie zum Beispiel in Fig. 2 dargestellt, umfasst eine Vakuumkammer zur Durchführung einer Plasmabehandlung vorzugsweise: einen Bereich zur Durchführung von Plasmabehandlungen, welcher Bereich von den Kammerwänden eingeschlossen ist; eine Plasmaquelle umfassend zumindest eine Bogenkathode eines kathodischen Vakuumbogenverdampfers, der an einer Kammerwand innerhalb der Kammer angeordnet und mit einem Netzteil verbunden ist; wobei der positive Pol des Netzteiles als die Bogenelektronen fangende Bogenanode einfacher Weise mit der Kammerwand verbunden ist. Es befindet sich eine Abschirmung vor dem kathodischen Vakuumbogenverdampfer. Es wird eine elektronen-aufnehmende Elektrode, an einer Kammerwand angebracht. Diese Elektrode wird mit dem positiven Pol eines weiteren Netzteils verbunden sein, so dass Bogenelektronen auf diese Elektrode hin beschleunigt werden können. Diese das Gasplasma erzeugende Elektrode hat eine im Wesentlichen zweidimensioanle Oberfläche zum Auffangen der von der Bogenentladung erzeugten Elektronen. Bevorzugt liegt die zweidimensionale Oberfläche der ersten Elektrode im Bereich zwischen 5 und 2000 cm², vorzugsweise zwischen 25 und 320 cm².

Bei einem anderen erfindungsgemässen Ausführungsbeispiel umfasst eine Vakuumkammer zur Durchführung einer Plasmabehandlung wie folgt: einen Bereich zur Durchführung von Plasmabehandlungen, wobei der Bereich von den Kammerwänden umschlossen wird; eine Plasmaquelle umfassend mindestens eine Kathode, die an einer Kammerwand innerhalb der Kammer angeordnet und mit einem Netzteil verbunden ist; eine erste Elektrode, die innerhalb der Kammer beabstandet von der mindestens einen Kathode an einer der Kammerwände angeordnet ist; eine zweite Elektrode, die innerhalb der Kammer beabstandet von der mindestens einen Kathode an einer der weiteren Kammerwände angeordnet ist; sowie ein erstes Netzteil, wobei das erste Netzteil mit der ersten Elektrode oder mit der ersten und der zweiten Elektrode verbunden ist, und wobei jeder der beiden als erste und zweite Elektrode bezeichneten Elektroden als Anode betrieben wird und jeweils eine zweidimensionale Oberfläche zum Auffangen der von der mindestens ersten Kathode emittierten Elektronen umfasst. Die zweidimensionale Oberfläche zum Auffangen der von der Kathode emittierten Elektronen liegt sowohl für die erste Elektrode als auch für die zweite Elektrode jeweils im Bereich zwischen 5 und 2000 cm², vorzugsweise zwischen 25 und 320 cm².

Gemäss einem weiteren Beispiel umfasst eine Plasmaquelle wie folgt: eine vakuumdichte Kammer; eine erste Kathode, die in der Kammer angeordnet ist; eine zweite Kathode, die in der Kammer angeordnet ist; eine erste Elektrode, die beabstandet von der ersten Kathode in der Kammer angeordnet ist; und eine zweite Elektrode, die beabstandet von der zweiten Kathode in der Kammer angeordnet ist, wobei die von der ersten Kathode emittierten Elektronen selektiv in Richtung zur ersten Elektrode und die von der zweiten Kathode emittierten Elektronen selektiv in Richtung zur zweiten Elektrode fliessen.

### KURZE BESCHREIBUNG DER ZEICHNUNGEN

In allen Zeichnungen und in der gesamten Beschreibung bezeichnen gleiche Bezugszeichen die gleichen Elemente, Merkmale und Strukturen. Die relative Grösse und Darstellung dieser Elemente kann, aus Gründen der Klarheit, Veranschaulichung oder Zweckmässigkeit nicht massgerecht sein.
Fig. 1 zeigt ein Beispiel einer bekannten Vakuumkammer zur Durchführung einer Plasmabehandlung.
Fig. 2 zeigt eine schematische Darstellung einer erfindungsgemässen Vakuumkammer zur Durchführung einer Plasmabehandlung mit einer Elektrode gemäss einem ersten Ausführungsbeispiel.
Fig. 2 a zeigt eine schematische Darstellung einer erfindungsgemässen Vakuumkammer zur Durchführung einer Plasmabehandlung mit einer rechteckigen Elektrode gemäss einem weiteren Ausführungsbeispiel.
Fig. 2 b zeigt eine schematische Darstellung einer erfindungsgemässen Vakuumkammer zur Durchführung einer Plasmabehandlung mit einer Elektrode mit einem Schalter zwischen Elektrode und Stromversorgung gemäss einem weiteren Ausführungsbeispiel.
Fig. 2 c zeigt eine schematische Darstellung einer erfindungsgemässen Vakuumkammer zur Durchführung einer Plasmabehandlung mit einer Elektrode mit einem Schalter zur Umpolung einer Stromversorung gemäss einem weiteren Ausführungsbeispiel.

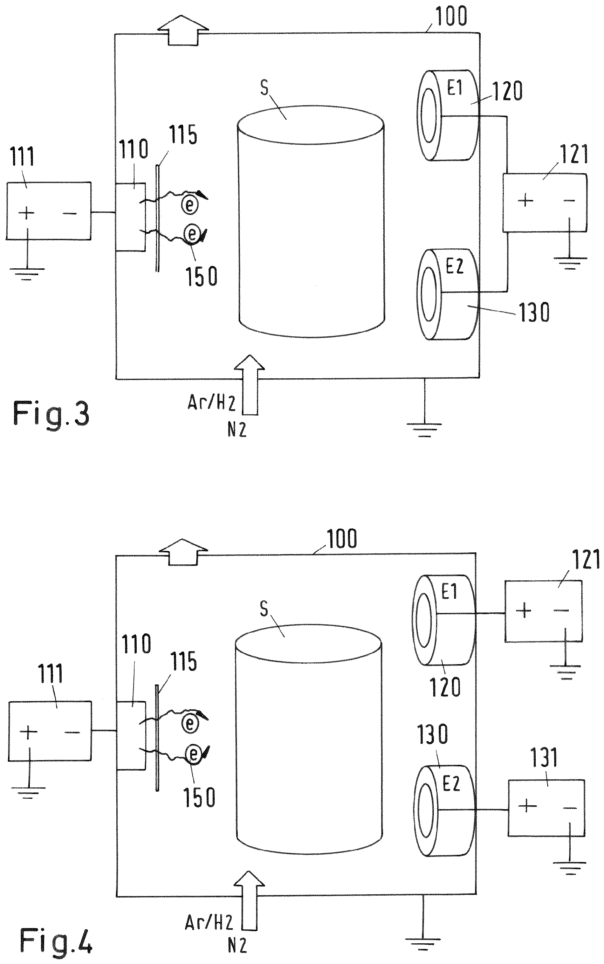

Fig. 3 zeigt eine schematische Darstellung einer erfindungsgemässen Vakuumkammer zur Durchführung einer Plasmabehandlung mit zwei erfindungsgemässen Elektroden mit einem Netzteil gemäss einem anderen Ausführungsbeispiel.
Fig. 4 zeigt eine schematische Darstellung einer erfindungsgemässen Vakuumkammer zur Durchführung einer Plasmabehandlung mit zwei erfindungsgemässen Elektroden mit zwei Netzteilen gemäss einem weiteren Ausführungsbeispiel.

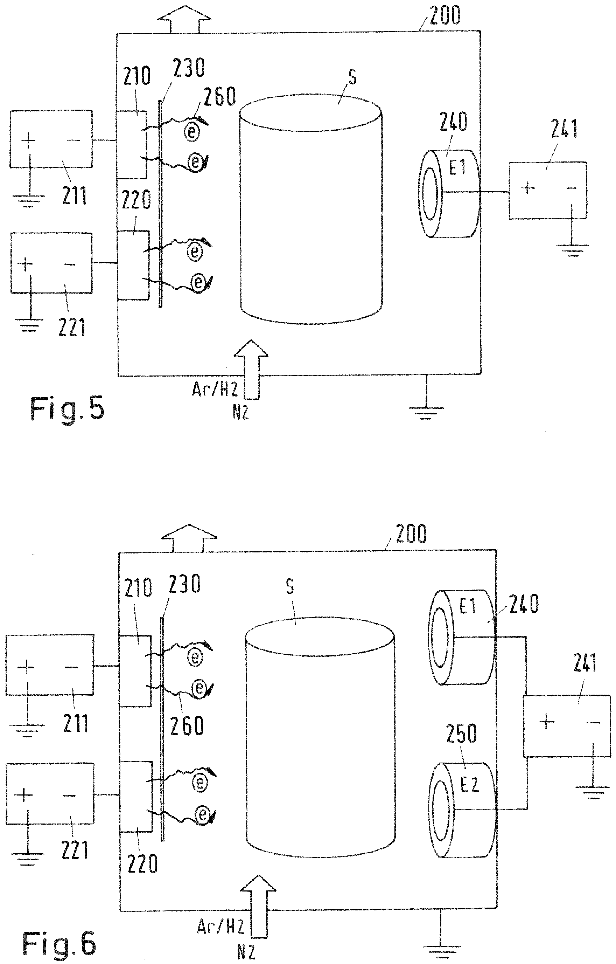

Fig. 5 zeigt eine schematische Darstellung einer erfindungsgemässen Vakuumkammer zur Durchführung einer Plasmabehandlung mit einer erfindungsgemässen Elektrode und zwei Kathoden gemäss einem weiteren Ausführungsbeispiel.
Fig. 6 zeigt eine schematische Darstellung einer erfindungsgemässen Vakuumkammer zur Durchführung einer Plasmabehandlung mit zwei erfindungsgemässen Elektroden und zwei Kathoden gemäss einem weiteren Ausführungsbeispiel.

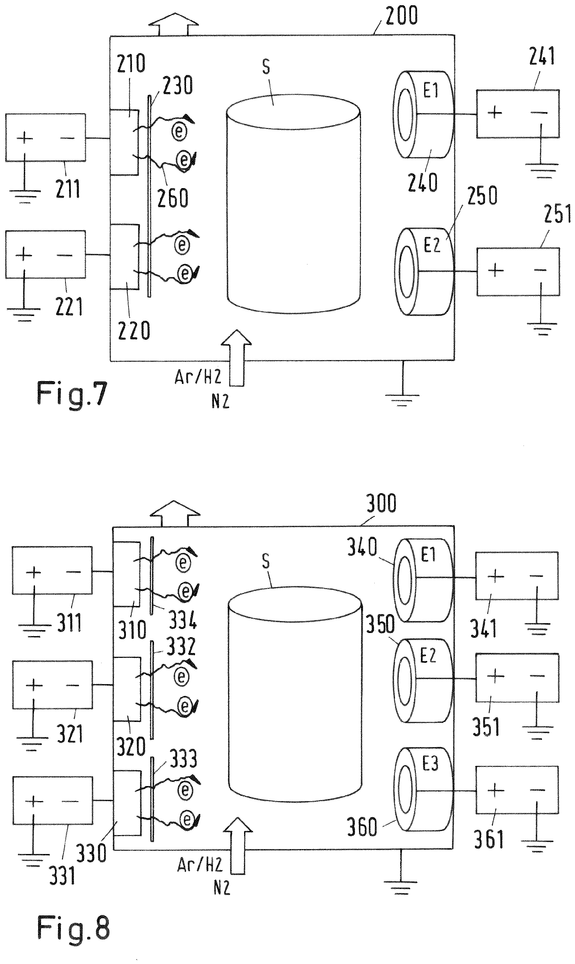

Fig. 7 zeigt eine schematische Darstellung einer erfindungsgemässen Vakuumkammer zur Durchführung einer Plasmabehandlung mit zwei erfindungsgemässen Elektroden und zwei Kathoden gemäss einem weiteren Ausführungsbeispiel.

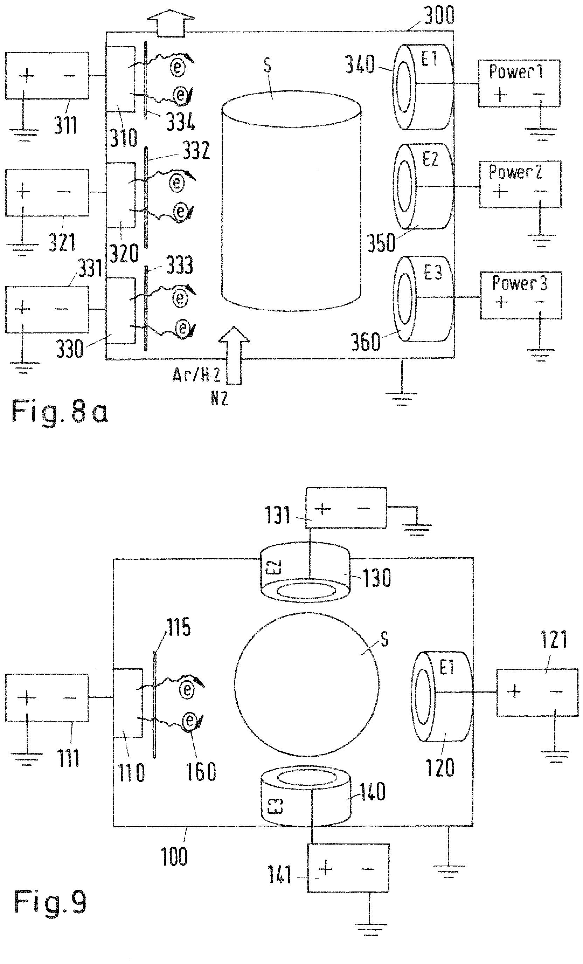

Fig. 8 zeigt eine schematische Darstellung einer erfindungsgemässen Vakuumkammer zur Durchführung einer Plasmabehandlung mit drei erfindungsgemässen Elektroden und drei Kathoden gemäss einem weiteren Ausführungsbeispiel.
Fig. 8 a zeigt eine schematische Darstellung einer erfindungsgemässen Vakuumkammer zur Durchführung einer Plasmabehandlung mit drei erfindungsgemässen Elektroden und drei Kathoden gemäss einem weiteren Ausführungsbeispiel.

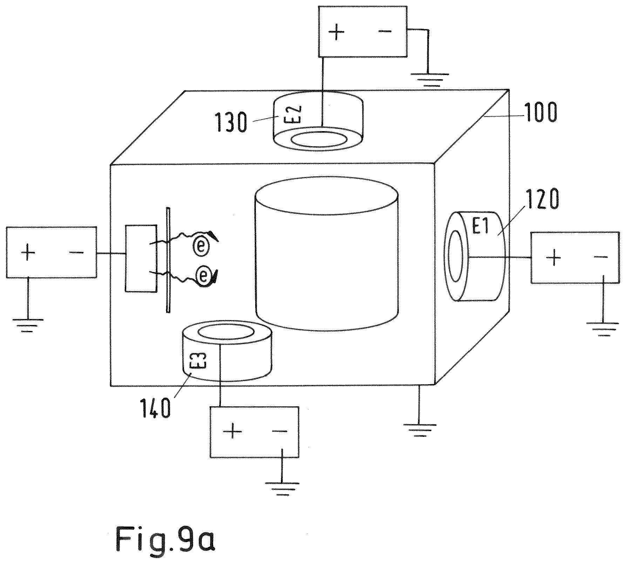

Fig. 9 zeigt eine schematische Darstellung einer erfindungsgemässen Vakuumkammer zur Durchführung einer Plasmabehandlung mit drei erfindungsgemässen Elektroden, an verschiedenen Kammerwänden gemäss einem anderen Ausführungsbeispiel.
Fig. 9 a zeigt eine schematische Darstellung einer erfindungsgemässen Vakuumkammer zur Durchführung einer Plasmabehandlung mit drei erfindungsgemässen Elektroden, an verschiedenen Kammerteilen gemäss einem anderen Ausführungsbeispiel.

### DETAILLIERTE BESCHREIBUNG

In den Zeichnungen sind Beispiele beschrieben, die ein oder mehrere Ausführungsbeispiele umfassen. Dabei ist die Erfindung nicht auf die beschriebenen Beispiele beschränkt. Zum Beispiel können ein oder mehrere Merkmale eines Ausführungsbeispiels auch in einem anderen Ausführungsbeispiel verwirklicht sein oder sogar in einem anderen Typ von Vorrichtung vorgesehen werden.

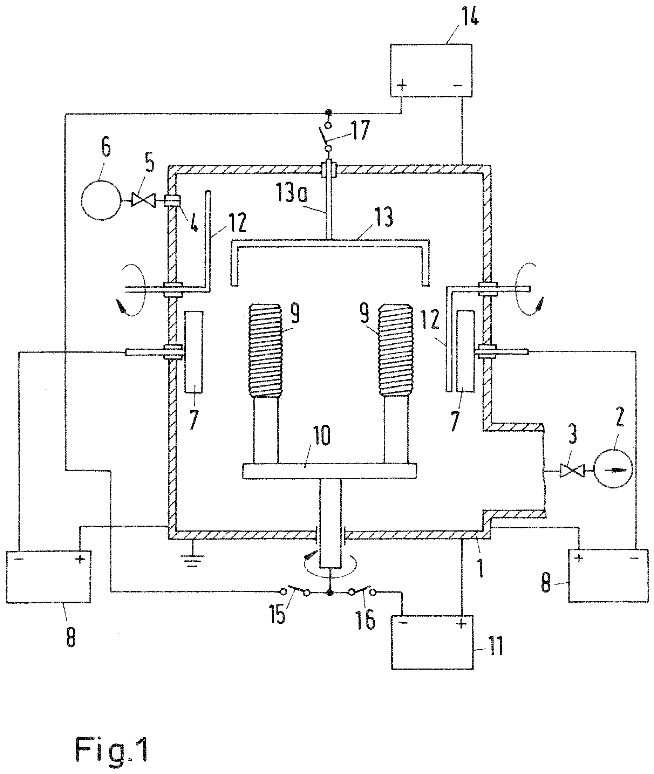

Bevor ein Beschichtungsprozess, wie zum Beispiel eine Beschichtung mittels physikalischer Gasabscheidung (PVD) oder eine diamantähnliche Kohlenstoffbeschichtung durchgeführt wird, kann ein Lichtbogen unterstützter Glimmentladungsprozess (auch lonenätzprozess) auf einem oder mehreren Substraten ausgeführt werden. Dabei wird der lonenätzprozess verwendet, um die Oberflächen vorzubereiten bzw. zu konditionieren, das heisst, die Substratoberflächen werden mittels eines Ionen Bombardements erhitzt und geäzt. Diese Konditionierung verbessert die Bindung zwischen dem Substrat und der Beschichtung. In Fig. 1 ist ein konventionelles lonenätzsystem dargestellt. Das Sytem der Fig. 1 umfasst eine Vakuumkammer 1 mit Verdampfern 7 (Verdampfer im Folgenden kurz für Bogenkathode eines kathodischen Vakuumbogenverdampfers), die an gegenüberliegenden Seiten der Kammer 1 angeordnet sind. Die Verdampfer 7 sind mit Gleichstromquellen 8 verbunden und können bei Spannungen von 40 V und Strömen bis zu 300 A betrieben werden. Shutter oder Abschirmungen 12 sind mit den Wänden der Kammer 1 verbunden und sind derart rotierbar angeordnet, dass die Shutter 12 so rotiert werden können, dass die entsprechende Elektrode 7 entweder abgeschmirmt oder nicht abgeschirmt ist. Eine lineare Elektrode 13 ist mit der Kammer verbunden und gleich von den Verdampfern 7 beabstandet. Die lineare Elektrode 13 kann an die Stromquellen 11, 14 über Schalter 15, 16, 17 verbunden werden und besitzt im Betriebszustand eine gleiche Spannung längs der Elektrode 3. Die Stromquellen 11, 14 sind ausserdem mit der Wand der Kammer 1 verbunden und können wahlweise über die Schalter 15, 16 mit einem rotierbaren Substrathalter 10 verbunden werden. Über das Ventil 5 kann Gas, wie zum Beispiel Argon, von einer Gasquelle 6 über den Einlass 4 in die Kammer 1 eingelassen werden, wenn eine Lichtbogenentladung gezündet wird, werden vom Verdampfer 7 Elektronen erzeugt und ich Richtung der linearen Elektrode 13 beschleunigt. Die Elektronen regen die Argongas Atome an und erzeugen so teilweise ionisierte Argonatome, die auf einer Oberfläche eines Substrats 9 abgesetzt werden um diese so für die Beschichtung vorzubereiten. Dieses System kann nur mittels der Gleichstromquellen 8, 11, 14 und dem rotierenden Substrathalter 10 eingestellt werden. Somit ist das Sytem durch begrenzte lonisation, begrenzte Einstellbarkeit der Palsmaaktivierung durch die lineare Elektrode 13, sowie begrenzte Einstellbarkeit der Homogenität in der Kammer 1 gekennzeichnet.

In Fig. 3, 4 und 9 sind nun Ausführungsbeispiele von Plasmaquellen schematisch dargestellt. Um den Fluss von Elektronen in der Kammer 100 (also eine erfindungsgemässe Vakuumkammer, im folgenden als Kammer bezeichnet) besser kontrollieren zu können, sind, anders als bei der eine lineare Elektrode umfassenden Vorrichtung gemäss Fig. 1, eine Vielzahl von erfindungsgemässen Elektroden 120, 130, 140 mit einer zweidimensionale Oberfläche zum Auffangen der von einer Kathode emittierten Elektronen vorgesehen, die in der Kammer angeordnet werden können. Ein sehr wichtiger Vorteil dieser Anordnung besteht in der Möglichkeit die Elektroden an einer oder mehreren Wänden der Kammer zu positionieren, wodurch eine Verbesserung einer Verteilung der mit Plasma zu-behandelnden Substrate in der Kammer ermöglicht wird. Dadurch kann in der Kammer der Bereich zur Plasmabehandlung besser ausgenutzt werden, wodurch eine höhere Effizienz erzielt wird. Beispielsweise ist in Fig. 3 oder 4 eine vakuumdichte Kammer 100 schematisch dargestellt, Ein Verdampfer 110 ist in der Kammer 100 vorgesehen und kann unmittelbar in die Wand oder an die Wand der Kammer 110 angeordnet werden. Der Verdampfer 110 kann eines oder mehrere Metalle, wie zum Beispiel Titan und / oder jedes andere zur Verdampfung vorgesehene Metall umfassen. Ein negativer Pol des Netzteils oder der Stromquelle ist mit dem Verdampfer 110 verbunden und verbindet den Verdampfer 110 somit in Form einer Kathode. Wenn der Verdampfer 110 zum Beispiel mittels einer Triggereinheit gezündet wird, werden Bogenelektronen emittiert, welche mittels der erfindungsgemässen Elektrode beschleunigt werden und stossen mit einem oder mehreren Gasen wie zum Beispiel Argon (Ar), Neon (Ne) oder irgendeinem anderen geeigneten Gas oder Gasen zusammen, die in die Kammer 110 eingelassen wurden, und erzeugen so ein Plasma. Die Ionen des Plasmas bombardieren dann die Oberflächen des einen oder der mehreren Substrate (hier nicht gezeigt), die in der Kammer 100 vorgesehen sind, um deren Oberflächen zum Beispiel durch Reinigung oder Ätzen für einen nachfolgenden Beschichtungsprozess vorzubereiten. Eine oder mehrere Abschirmungen 115 sind in der Kammer 100 beweglich vorgesehen, so dass die Abschirmung 115 wahlweise zwischen dem Verdampfer 110 und dem Substrat positioniert werden kann. Somit kann vor der Zündnung des Lichtbogen Prozesses die Abschirmung 115 entweder rotiert oder in anderer Weise vor den Verdampfer bewegt werden, um die Substrate vor Verunreinigungen durch den Verdampfer 110 während dieses Prozesses zu schützen. Wenn der Lichtbogen nicht vorhanden ist, kann die Abschirmung in eine andere geeignete Position bewegt werden.

Gemäss Fig. 3 und 4 sind zwei Elektroden, eine erste Elektrode 120 und eine zweite Elektrode 130 in der Kammer 100 vorgesehen. Die erste und zweite Elektrode 120, 130 sind mit einem postiven Pol des zumindest eines Netzteils oder Stromquelle verbunden und verbinden damit die erste und zweite Elektrode 120, 130 als erste und zweite Anode. Beispielsweise kann wie in Fig. 3 dargestellt ein gemeinsames Netzteil 121 mit der ersten Elektrode 120 und der zweiten Elektrode 130 verbunden werden. In dieser Anordnung kann eine gleiche Spannung an die erste Elektrode 120 und die zweite Elektrode 130 angelegt werden. Diese Spannung kann an beide Elektroden 120, 130 zur selben Zeit und für dieselbe Zeitdauer angelegt werden. Alternativ kann gemäss Fig. 4 ein erstes Netzteil 121 die erste Elektrode 120 während eines ersten Zeitintervalls mit einem Strom versorgen und ein zweites Netztteil 131 die zweite Elektrode 130 während eines zweiten Zeitintervalls mit einem Strom versorgen. Das erste und das zweite Zeitintervall können je nach Wunsch voneinander getrennt oder überlappend sein. In einem anderen Beispiel kann die erste Elektrode 120 mit einem ersten Netzteil 121 verbunden sein und die zweite Elektrode 130 kann mit einem zweiten Netzteil 131 verbunden sein. Somit kann das erste Netzteil 121 die erste Elektrode 120 mit einem ersten Strom versorgen und das zweite Netzteil 131 kann die zweite Elektrode 130 mit einem zweiten Strom versorgen. Durch die Verwendung von unterschiedlichen Strömen und / oder unterschiedlichen Zeitintervallen kann das im System erzeugte Plasma beeinflusst, gesteuert oder auch homogenisiert werden.

Wie in Fig. 3 und 4 dargestellt, fliessen die vom Verdampfer 110 emittierten Elektronen zu den Positionen der ersten und zweiten Elektroden 120, 130. Durch geeignete Positionierung der individuellen ersten Elektrode 120 und zweiten Elektrode 130 an den gewünschten Orten ist eine bessere Kontrolle des Plasmaflusses in der Kammer 100 möglich und folglich eine verbesserte Kontrolle des lonenbombardements und Ätzens des Substrats S. Fig. 9 illustriert ein Ausführungsbeispiel, bei welchem drei einzelne Elektroden, eine erste Elektrode 120, eine zweite Elektrode 130 und eine dritte Elektrode 140 vorgesehen sind. Somit resultiert ein entsprechender erster, zweiter und dritter Elektronenweg 160, der jeweils in Richtung der ersten, zweiten und dritten Elektrode 120, 130, 140 gerichtet ist. In den schematischen Zeichnungen gemäss Fig. 3 und 4 sind die Elektroden 120, 130 gegenüber dem Verdampfer 110 angeordnet. In der schematischen Zeichnungen gemäss Fig. 9 sind die Elektroden 120, 130, 140 hingegen an verschiedenen Kammerteilen angeordnet. Es versteht sich jedoch, dass jede geeignete Positionierung der ersten, zweiten oder optional auch dritten Elektrode möglich ist, um den Elektronenfluss derart zu beeinflussen, dass eine verbesserte Plasmaaktivierung und Homogenität in der Kammer erreichbar ist. Entsprechend ist jede Anzahl von Elektroden in der Kammer möglich, um den Elektronenfluss auf eine gewünschte Bahn zu lenken. Der Verdampfer 110 gemäss Fig. 3, 4 und 9 kann mit einem angelegten Strom von 100 A verwendet werden; jedoch kann selbstverständlich auch jede andere geeignete Stromstärke verwendet werden.

Fig. 6 zeigt ein weiteres Ausführungsbeispiel einer Plasmaquelle, bei welcher mehrere Verdampfer vorgesehen sind. Eine Kammer 200 umfasst einen ersten Verdampfer 210 und einen zweiten Verdampfer 220, die als Kathoden angeschlossen sind. Der erste und zweite Verdampfer 210, 220 kann in der Wand der Kammer 200 oder anders an der Kammer 200 vorgesehen sein. Alternativ kann der erste oder zweite Verdampfer 210, 220 auch an einer geeigneten Struktur der Kammer 200 oder in der Kammer 200 angeordnet sein. Eine rotierbare oder anders bewegbare Abschirmung 230 ist in der Nähe des ersten und zweiten Verdampfers 210, 220 vorgesehen. Die Abschirmung 230 kann eine Grösse haben, die ausreicht, um beide Verdampfer 210, 220 abzuschirmen. Alternativ kann die Kammer 200 eine erste und zweite Abschirmung umfassen, die jeweils zum ersten Verdampfer 110 und zum zweiten Verdampfer 220 gehört. Ausserdem ist in der Kammer 200 eine erste Elektrode 240 und eine zweite Elektrode 250 vorgesehen, welche beide als Anode angeschlossen sind. Wie durch die Elektronenwege 260 dargestellt, fliessen die vom ersten Verdampfer 210 emittierten Elektronen in Richtung zur ersten Elektrode 240 und die vom zweiten Verdampfer 220 emittierten Elektronen in Richtung zur zweiten Elektrode 250. Es versteht sich, dass jede gewünschte Anzahl von Verdampfern mit jeder gewünschten Anzahl von individuellen Elektroden benutzt werden kann. So kann das System der Fig. 6 zum Beispiel zwei Verdampfer und vier individuelle Elektroden umfassen, so dass Elektronen vom ersten Verdampfer 210 zu zwei idndividuellen Elektroden fliessen und die Elektronen vom zweiten Verdampfer zu zwei anderen individuellen Elektroden fliessen.

Das Ausführungsbeispiel gemäss Fig. 8 kann insbesondere in grossen Systemen zur Anwendung kommen. Mehrere Plasmaquellen können in der Kammer vorgesehen sein, indem Verdampfer 311, 321, 331 und Elektroden 340, 350, 360 entlang der Höhe der Kammer, das heisst entlang der Höhe des Plasmabehandlungsbereichs angeordnet sind, wobei die Plasmaquelle in jedem Fall mindestens einen Verdampfer und eine, zwei oder mehr einzelne Elektroden umfasst. Dabei kann jede Elektrode von einem eigenen Netzteil versorgt werden oder aber ein schaltbares Netzteil kann von mehreren Elektroden gleichzeitig benutzt werden.

Das Ausführungsbeispiel gemäss Fig. 2 zeigt eine schematisch dargestellte vakuumdichte Kammer 100, einen Verdampfer 110, welcher in der Kammer 100 vorgesehen ist und unmittelbar an der Wand der Kammer 100 angeordnet werden kann. Ausserdem ist ein Netzteil 111 vorgesehen, welches einen negativen Pol besitzt. Dieser negative Pol des Netzteils 111 oder der Stromquelle 111 ist mit dem Verdampfer 110 verbunden. Im vorliegenden Ausführungsbeispiel ist der Verdampfer 110 somit eine Kathode 110. Der Verdampfer 110 emittiert wie dargestellt Bogenelektronen, die mit der erfindungsgemässen Elektrode zunächst teilweise abgesogen und beschleunigt werden und somit das Arbeitsgas Argon (Ar) (oft auch Neon (Ne) oder irgendeinem anderen geeigneten Gas oder Mischung von Gasen) anregen und folglich ein Plasma erzeugen. Dazu wird an die Elektrode 120 eine positive Beschleunigungsspannung angelegt, die einen Elektrodenstrom zur Elektrode ermöglicht. Die Steuerung der Elektrode kann allgemein über die Spannung oder den Strom erfolgen, oder aber auch durch die Energie bestehend aus dem Produkt von Spannung und Strom erfolgen. Die Ionen des Plasmas treffen dann auf eine Oberfläche des Substrates S, welches vorzugsweise zentiert in der Kammer 100 vorgesehen ist, um dessen Oberflächen zum Beispiel durch Reinigung oder Ätzen für einen nachfolgenden Beschichtungsprozess vorzubereiten und zu aktivieren. In der Kammer 100 der Fig. 2 ist ausserdem eine Abschirmung 115 beweglich angeordnet, sodass die Abschirmung 115 wahlweise zwischen dem Verdampfer 110 und dem Substrat S positioniert werden kann. Somit kann vor der Zündnung des Lichtbogenprozesses die Abschirmung 115 entweder rotiert oder in anderer Weise vor den Verdampfer 110 bewegt werden, um das Substrat S vor Verunreinigungen durch den Verdampfer 110 während dieses Prozesses zu schützen. Wenn der Lichtbogen nicht vorhanden ist, kann die Abschirmung in eine andere geeignete Position bewegt werden.

Gemäss Fig. 2 ist eine einzige Elektrode 120 vorgesehen. Die Elektrode 120 ist mit einem postiven Pol eines Netzteils 121 verbunden und die Elektrode 120 ist folglich eine Anode 120. Durch die Verwendung von unterschiedlichen Strömen und / oder unterschiedlichen Zeitintervallen an der Stromquelle 121 der Anode 120 kann das im System erzeugbare Plasma beeinflusst werden.

Wie in Fig. 2 dargestellt, werden die vom Verdampfer 110 emittierten Elektronen zur Position der Elektroden/Anoden 120 entlang eines ersten und eines zweiten Elektronenweges 150 geführt. Somit ist wiederum ein in der Kammer 100 generierbares Plasma in dieselbe Richtung beschleunigbar. Durch geeignete Positionierung der ersten Elektrode 120 an einer gewünschten Position ist eine bessere / einfachere Kontrolle des Plasmaflusses in der Kammer 100 möglich und folglich eine verbesserte Kontrolle des lonenbeschusses und Ätzens des Substrates.

Das Ausführungsbeispiel gemäss Fig. 2a zeigt eine schematisch dargestellte vakuumdichte Kammer 100 mit einem analogen Aufbau wie die Kammer 100 gemäss Ausführungsbeispiel gemäss Fig. 2. Die zweidimensionale Oberfläche zum Auffangen der von der Kathode emittierten Elektronen der ersten Elektrode 120a gemäss Fig. 2a ist jedoch rechteckig, wohingegen die zweidimensionale Oberfläche der ersten Elektrode 120 gemäss Fig. 2 kreisförmig ist. Hierbei besitzt die zweidimensionale Oberfläche zum Auffangen der von dem Verdampfer emittierten Elektronen, eine zu einer Oberflächennormalen erste orthogonale Ausdehnung und eine zweite orthogonale Ausdehnung, wobei die erste orthogonale Ausdehnung senkrecht zu der zweiten orthogonalen Ausdehnung verläuft und ein Längenverhältnis der ersten orthogonalen Ausdehnung zu der zweiten orthogonalen Ausdehnung zwischen 0,4 und 1 liegt. Bei der kreisförmigen Elektrode 120 entsprechen die erste orthogonale Ausdehnung und die zweite orthogonale Ausdehnung insbesondere dem Durchmesser der zweidimensionalen Oberfläche. Bei der rechteckigen Elektrode 120a entspricht die erste orthogonale Ausdehnung einer ersten Kantenlänge und die zweite orthogonale Ausdehnung einer zweiten Kantenlänge der zweidimensionalen Oberfläche.

Das Ausführungsbeispiel gemäss Fig. 2b zeigt eine schematisch dargestellte vakuumdichte Kammer 100 mit einem analogen Aufbau wie die Kammer 100 gemäss Ausführungsbeispiel gemäss Fig. 2. Das Ausführungsbeispiel gemäss Fig. 2b umfasst jedoch eine zwischen die erste Elektrode 120 und die Netzteile 121, 122 geschaltete Schaltervorrichtung 123. Das Netzteil 121 ist mit dem positiven Pol am Schalter S1 der Schaltervorrichtung 123 angeordnet und das Netzteil 122 ist mit dem negativen Pol am Schalter S2 der Schaltervorrichtung 123 angeordnet. Ist der Schalter S1 geschlossen und der Schalter S2 offen kann die Elektrode 120 als erfindungsgemässe Plasmaelektrode (also auch Anode) verwendet werden. Ist Schalter S1 offen und Schalter S2 geschlossen kann die Elektrode 120 für (Bogen-)Beschichtungsverfahren oder Sputterprozesse (also Target) verwendet werden.

Das Ausführungsbeispiel gemäss Fig. 2c zeigt eine schematisch dargestellte vakuumdichte Kammer 100 mit einem analogen Aufbau wie die Kammer 100 gemäss Ausführungsbeispiel gemäss Fig. 2. Das Ausführungsbeispiel gemäss Fig. 2c umfasst jedoch eine zwischen die erste Elektrode 120 und das Netzteile 121 geschaltete Schaltervorrichtung 123. Das Netzteil 121 ist mit dem positiven Pol am Schalter S1 der Schaltervorrichtung 123 angeordnet und mit dem negativen Pol am Schalter S2 der Schaltervorrichtung 123 angeordnet. Ausserdem ist das der positive Pol des Netzteils 121 über die einen Schalter S3 mit einer Erdung verbunden und der negative Pol des Netzteils 121 über die einen Schalter S4 mit der Erdung verbunden. Ist der Schalter S1 geschlossen, der Schalter S2 offen, der Schalter S3 offen und der Schalter S4 geschlossen, kann die Elektrode 120 als erfindungsgemässe Plasmaelektrode verwendet werden. Ist Schalter S1 offen und Schalter S2 geschlossen der Schalter S3 geschlossenund der Schalter S4 offen, kann die Elektrode 120 für (Bogen-)Beschichtungsverfahren oder Sputterprozesse verwendet werden.

Das Ausführungsbeispiel gemäss Fig. 3 zeigt die schematisch dargestellte vakuumdichte Kammer 100. Hierbei sind die erste Elektrode 120 und die zweite Elektrode 130 mit einem positiven Pol desselben Netzteils 121 oder derselben Stromquelle 121 verbunden. Folglich sind die erste Elektrode 120 und die zweite Elektrode 130 eine erste Anode 120 und eine zweite Anode 130. Durch die Verwendung von unterschiedlichen Strömen und / oder unterschiedlichen Zeitintervallen an der Stromquelle 121 der Anoden 120 und 130 kann das im System erzeugbare Plasma beeinflusst werden.

Da das gemeinsame Netzteil mit der ersten Elektrode 120 und der zweiten Elektrode 130 verbunden ist, kann mit dieser Anordnung eine gleiche Spannung an die erste Elektrode 120 und die zweite Elektrode 130 angelegt werden. Dieser Strom kann an beide Elektroden 120, 130 zur selben Zeit und für dieselbe Zeitdauer angelegt werden.

Das Ausführungsbeispiel gemäss Fig. 4 zeigt die schematisch dargestellte vakuumdichte Kammer 100. Bei dem Ausführungsbeispiel gemäss Fig. 4 ist an der ersten Elektrode 120 eine erstes Netzteil 121 und an der zweiten Elektrode 130 eine zweites Netzteil 131 angeordnet ist. Hierbei kann durch die Verwendung von unterschiedlichen Strömen und / oder unterschiedlichen Zeitintervallen an dem ersten Netzteil 121 und dem zweiten Netzteil 131 das im System erzeugbare Plasma beeinflusst werden, insbesondere da das erste Netzteil die erste Elektrode 120 mit einem ersten Strom versorgen und das zweite Netzteil kann die zweite Elektrode 130 mit einem zweiten Strom versorgen. Der erste und zweite Strom, können hierbei unabhängig voneinander einstellbar sein, sodass die Verteilung des Plasmas durch den ersten und den zweiten Strom formbar ist. Hierbei kann das erste Netzteil 121 die erste Elektrode 120 während eines ersten Zeitintervalls mit dem ersten Strom versorgen und das zweite Netzteil 131 die zweite Elektrode 130 während eines zweiten Zeitintervalls mit dem zweiten Strom versorgen. Das erste und das zweite Zeitintervall können je nach Wunsch voneinander getrennt oder überlappend sein.

In den Ausführungsbeispielen gemäss Fig. 2-4 liegt jeweils ein einziger Verdampfer 110 vor, wodurch ein Plasmabogen erzeugt wird, mit mindestens einer Anode 120, 130.

Fig. 5 zeigt ein weiteres Ausführungsbeispiel einer Kammer 200, bei welcher mehrere Verdampfer vorgesehen sind. Die Kammer 200 umfasst einen ersten Verdampfer 210 und einen zweiten Verdampfer 220, die als Kathoden angeschlossen sind, also mit einem negativen Pol einer ersten Netzteils 211 und eines zweiten Netzteils 221 verbunden sind. Der erste und zweite Verdampfer 210, 220 sind an der Wand der Kammer 200 vorgesehen. Alternativ kann der erste oder zweite Verdampfer 210, 220 auch an einer geeigneten Struktur der Wand der Kammer 200 oder in der Kammer 200 angeordnet sein. Eine rotierbare oder anders bewegbare Abschirmung 230 ist in der Nähe des ersten und zweiten Verdampfers 210, 220 vorgesehen. Die Abschirmung 230 kann eine Grösse haben, welche ausreicht, um beide Verdampfer 210, 220 abzuschirmen. Alternativ kann die Kammer 200 eine erste und zweite Abschirmung umfassen, die jeweils zum ersten Verdampfer und zum zweiten Verdampfer 210, 220 gehört (hier nicht gezeigt). Ausserdem ist in der Kammer 200 eine erste Elektrode 240 vorgesehen, welche als Anode angeschlossen ist, also mit dem postiven Pol einer ersten Stromquelle 241 verbunden ist. Wie durch die Elektronenwege 260 dargestellt, fliessen die vom ersten Verdampfer 210 emittierten Elektronen und die vom zweiten Verdampfer 220 emittierten Elektronen in Richtung der ersten Elektrode 240. Es versteht sich, dass jede gewünschte Anzahl von Verdampfern mit jeder gewünschten Anzahl von individuellen Elektroden benutzt werden kann, sodass das System eine geeignete Anzahl von Verdampfern und eine geeignete Anzahl von Elektroden umfassen kann.

Das Ausführungsbeispiel gemäss Fig. 6 zeigt eine schematisch dargestellte vakuumdichte Kammer 200 mit einem analogen Aufbau wie die Kammer 200 gemäss Ausführungsbeispiel gemäss Fig. 5. Das Ausführungsbeispiel gemäss Fig. 6 unterscheidet sich jedoch von Fig. 5 darin, dass eine erste Elektrode 240 und eine zweite Elektrode 250 vorliegen. Hierbei sind die erste Elektrode 240 und die zweite Elektrode 250 mit einem postiven Pol desselben Netzteils 241 oder derselben Stromquelle 241 verbunden. Folglich sind die erste Elektrode 240 und die zweite Elektrode 250 als eine erste Anode 240 und eine zweite Anode 250 geschaltet.

Da das gemeinsame Netzteil mit der ersten Elektrode 240 und der zweiten Elektrode 250 verbunden ist, kann in dieser Anordnung ein gleicher Strom an die erste Elektrode 240 und die zweite Elektrode 250 angelegt werden. Dieser Strom kann an beide Elektroden 240, 250 zur selben Zeit und für dieselbe Zeitdauer angelegt werden.

Das Ausführungsbeispiel gemäss Fig. 7 zeigt eine schematisch dargestellte vakuumdichte Kammer 200 mit einem analogen Aufbau wie die Kammer 200 gemäss Ausführungsbeispiel gemäss Fig. 6. Das Ausführungsbeispiel gemäss Fig. 7 unterscheidet sich jedoch von Fig. 6 darin, dass an der ersten Elektrode 240 ein erstes Netzteil 241 und an der zweiten Elektrode 250 eine zweites Netzteil 251 angeordnet ist. Hierbei kann durch die Verwendung von unterschiedlichen Strömen und / oder unterschiedlichen Zeitintervallen an des ersten Netzteils 241 und des zweiten Netzteils 251 das im System erzeugbare Plasma beeinflusst werden, insbesondere da das erste Netzteil die erste Elektrode 240 mit einem ersten Strom versorgen und das zweite Netzteil kann die zweite Elektrode 250 mit einem zweiten Strom versorgen. Der erste und zweite Strom können hierbei unabhängig voneinander einstellbar sein, sodass die Verteilung des Plasmas durch den ersten und den zweiten Strom formbar ist. Hierbei kann das erste Netzteil 241 die erste Elektrode 240 während eines ersten Zeitintervalls mit dem ersten Strom versorgen und das zweite Netzteil 251 die zweite Elektrode 250 während eines zweiten Zeitintervalls mit dem zweiten Strom versorgen. Das erste und das zweite Zeitintervall können je nach Wunsch voneinander getrennt oder überlappend sein.

In den Ausführungsbeispielen gemäss Fig. 5-7 liegen jeweils zwei Verdampfer 210, 220 vor mit mindestens einer Anode 240, 250.

Fig. 8 zeigt ein weiteres Ausführungsbeispiel der Kammer 300, bei welcher mehrere Verdampfer vorgesehen sind. Die Kammer 300 umfasst einen ersten Verdampfer 310, einen zweiten Verdampfer 320 und einen dritten Verdampfer 330, die als Kathoden angeschlossen sind, also mit einem negativen Pol eines ersten Netzteils 311, eines zweiten Netzteils 321 und eines dritten Netzteils 331 verbunden sind. Der erste, zweite und dritte Verdampfer 310, 320 und 330 sind an derselben Wand der Kammer 300 vorgesehen. Alternativ könnn der erste, zweite und dritte Verdampfer 310, 320 und 330 auch an einer geeigneten Struktur der Wand der Kammer 300 oder in der Kammer 300 angeordnet sein. Ausserdem können erste, zweite und dritte Verdampfer 310, 320 und 330 an verschiedenen Wänden, beziehungsweise erste und dritte Verdampfer 310 und 330 an einer Wand und der zweite Verdampfer 320 an einer anderen Wand. Drei rotierbare oder anders bewegbare Abschirmungen 334, 332 und 333 sind jeweils in der Nähe des ersten, zweiten und dritten Verdampfers 310, 320 und 330 vorgesehen. Alternativ kann die Kammer 300 eine Abschirmung umfassen, welche eine Grösse hat, welche ausreicht, um alle Verdampfer 310, 320, 330 abzuschirmen. Ausserdem ist in der Kammer 300 eine erste Elektrode 340, eine zweite Elektrode 350 und eine dritte Elektrode 360 vorgesehen, welche als Anoden 340, 350, 360 angeschlossens sind, also mit dem postiven Pol jeweils mit einem ersten Netzteil 341, einem zweiten Netzteil 351 und einem dritten Netzteil 361 verbunden ist. Wie durch die Elektronenwege dargestellt, fliessen die vom ersten Verdampfer 310 emittierten Elektronen, die vom zweiten Verdampfer 320 emittierten Elektronen und die vom dritten Verdampfer 330 emittierten Elektronen in Richtung der drei Anoden 340, 350, 360.

In der schematischen Zeichnung gemäss Fig. 8 sind die Elektroden 340, 350, 360 gegenüber dem Verdampfern 310, 320, 330 angeordnet. Es versteht sich jedoch, dass jede geeignete Positionierung der ersten, zweiten und dritten Elektrode möglich ist, um den Elektronenfluss derart zu beeinflussen, dass eine verbesserte Plasmaaktivierung und Homogenität in der Kammer erreichbar ist. Entsprechend ist jede Anzahl von Elektroden in der Kammer möglich, um den Elektronenfluss auf eine gewünschte Bahn zu lenken. Der an die Verdampfer 310, 320, 330 angelegte Strom kann 100 A betragen, jedoch kann selbstverständlich auch jede andere geeignete Stromstärke verwendet werden.

In dem Ausführungsbeispiel gemäss Fig. 8 liegen also drei Verdampfer 310, 320 und 330 vor mit drei Anoden 340, 350 und 360 vor.

Fig. 8 a zeigt ein weiteres Ausführungsbeispiel einer Kammer 300, mit einem analogen Aufbau zur Kammer in Fig. 8, jedoch werden die Netzteile der ersten Elektrode 340, der zweiten Elektrode 350 und der dritten Elektrode 360 mit verschiedenenen Energien betrieben. Über die verschiedenen Energien kann unter anderem die Homogenität eines Plasmas verbessert werden, als auch die Verteilung eines Plasmas besser gesteuert werden, indem die Energien an den jeweiligen Netzteilen entsprechend eingestellt werden.

Das Ausführungsbeispiel gemäss Fig. 9 zeigt eine schematisch dargestellte vakuumdichte Kammer 100 mit einem analogen Aufbau wie die Kammer 100 gemäss Ausführungsbeispiel gemäss Fig. 2. Das Ausführungsbeispiel gemäss Fig. 9 unterscheidet sich jedoch von Fig. 2 darin, dass eine erste Elektrode 120, eine zweite Elektrode 130 und eine dritte Elektrode 140 vorliegen und an der ersten Elektrode 120 einem ersten Nezteil 121, an der zweiten Elektrode 130 eine zweites Netzteil 131 und an der dritten Elektrode 140 eine drittes Netzteil 141 angeordnet ist. Hierbei kann durch die Verwendung von unterschiedlichen Energien und / oder unterschiedlichen Zeitintervallen an dem ersten Netzteil 121, dem zweiten Netzteil 131 und dem dritten Netzteil 141 das im System erzeugbare Plasma beeinflusst werden, insbesondere da das erste Netzteil 121 die erste Elektrode 120 mit einer ersten Energie versorgt und das zweite Netzteil131 kann die zweite Elektrode 130 mit einer zweiten Energie versorgen und das dritte Netzteil 141 kann die dritte Elektrode 140 mit einer dritten Energie versorgen. Die erste, zweite und dritte Energie können hierbei unabhängig voneinander einstellbar sein, sodass die Verteilung des Plasmas durch die erste, die zweite und die dritte Energie formbar ist.

Fig. 9 illustriert ein Ausführungsbeispiel, bei welchem also drei einzelne Elektroden, eine erste Elektrode 120, eine zweite Elektrode 130 und eine dritte Elektrode 140 vorgesehen sind. Somit resultiert ein entsprechender erster, zweiter und dritter Elektronenweg 160, der jeweils in Richtung der ersten, zweiten und dritten Elektrode 120, 130, 140 gerichtet ist. In den schematischen Zeichnungen gemäss Fig. 13 sind die Elektroden 120, 130, 140 gegenüber dem Verdampfer 110 angeordnet. Es versteht sich jedoch, dass jede geeignete Positionierung der ersten, zweiten oder optional auch dritten Elektrode möglich ist, um den Elektronenfluss derart zu beeinflussen, dass eine verbesserte Plasmaaktivierung und Homogenität in der Kammer erreichbar ist. Entsprechend ist jede Anzahl von Elektroden in der Kammer möglich, um den Elektronenfluss auf eine gewünschte Bahn zu lenken.

Wie aus den Fig. 4-8 erkenntlich kann das Susbtrat S sowohl negativ, als auch postiv vorgespannt werden, wobei die positive Vorspannung kleiner als die der Elektrode sein muss, da ansonsten die gesamten Elektronen zum Substrat fliessen. Selbstverständlich eignet sich ein entsprechend vorgespanntes Substrat auch zu zusätzlichen Plasmasteuerung. Ausserdem werden der Kammer 100, 200 im Betriebszustand ein Arbeitsgas und ein Prozessgas zugeführt. Das Arbeitsgas ist hierbei vorzugsweise Argon (Ar) und Wasserstoff (H₂) und das Prozessgas vorzugsweise Stickstoff (N₂).

Das Ausführungsbeispiel gemäss Fig. 9a zeigt eine schematisch dargestellte vakuumdichte Kammer 100 mit einem analogen Aufbau wie die Kammer 100 gemäss Ausführungsbeispiel gemäss Fig. 9. Bei Ausführungsbeispiel gemäss Fig. 9a sind die Elektroden 120, 130, 140 jedoch nicht nur an Kammerwänden der Kammer 100 angeordnet. Die erste Elektrode 120 ist an einer Kammerwand angeordnet, die zweite Elektrode 130 ist an einer Kammerdecke angeordnet und die dirette Elektrode 140 am Kammerboden. Die Anordnung der Elektroden in der Kammer kann, um unter anderem eine Plasmaverteilung zu steuern, beliebig angepasst werden.

In den Fig. 2-9a kann das Substrat S sowohl negativ als auch positiv vorgespannt werden, wobei die positive Vorspannung kleiner als die der Elektrode sein sollte, da ansonsten die gesamten Elektronen zum Substrat fliessen. Im Betriebszustand kann als Arbeitsgas vorzugsweise Argon (Ar) und Wasserstoff (H2) und als Prozessgas vorzugsweise Stickstoff (N2) zugeführt werden.

Während unterschiedliche beispielhafte Konfigurationen im Rahmen dieser Anmeldung gezeigt und beschrieben wurden, fallen natürlich auch weitere Ausführungsbeispiele mit jeglicher Anzahl von Verdampfern und jeglicher Anzahl von Elektroden in den Schutzbereich der hier beanspruchten Erfindung. Darüber hinaus kann eine erfindungsgemässe Vakuumkammer für lonenätzprozesse verwendet werden und mit einer Mehrzahl von einzelnen Elektroden ausgerüstet sein, wobei verschiedene Elektroden mit verschiedenen Strömen versorgt sein können. An die verschiedenen Elektroden können gleiche oder verschiedene Ströme, auch zu verschiedenen Zeiten angelegt werden, um die Plasmaaktivierung und das Ätzen in gewünschter Weise zu manipulieren.

Die in den Figuren enthaltenen Elektronenwege 150, 160, 260 sind nur schematisch dargestellt, da die Elektronenwege 150, 160, 260 selbstverständlich an den Abschirmungen 115, 230, 332, 333, 334 vorbeiführen und nicht durch diese hindurch.

Obwohl im Rahmen der vorliegenden Anmeldung bereits eine ganze Reihe von Ausführungsbeispielen beschrieben wurde, versteht es sich von selbst, dass weitere Variationen möglich sind. Zum Beispiel können die beschrieben Ausführungsformen in geeignter Weise kombiniert und ergänzt werden bzw. durch gleichwirkende äquivalente Merkmale ersetzt werden. Der Schutzbereich der Erfindung wird durch die Ansprüche begrenzt.

## Patentansprüche

1. Vakuumkammer zur Durchführung einer Plasmabehandlung umfassend einen Plasmabehandlungsbereich, der von Kammerwänden umschlossen ist, sowie eine Plasmaquelle umfassend:
eine Kathode (110, 210, 220, 310, 320, 330) zur kathodischen Vakuumbogenverdampfung mit einer Bogenanode die mit der Kammer verbunden ist, wobei die Kathode in der Kammer an der Kammerwand angeordnet ist;
eine von der Kathode (110, 210, 220, 310, 320, 330) beabstandete, in der Kammer angeordnete Elektrode (120, 120a, 130, 140, 240, 250, 340, 350, 360) zur Steuerung eines Plasmas in der Vakuumkammer;
**dadurch gekennzeichnet, dass**
die Plasmaquelle weiter umfasst:
eine Abschirmung (115, 230, 332, 333, 334) zur Abschirmung von Partikeln und Metallionen, die von der Kathode emittiert werden, wobei die Abschirmung (115, 230, 332, 333, 334) derart in der Vakuumkammer vorgesehen ist, dass sie vor der Kathode (110, 210, 220, 310, 320, 330) angeordnet werden kann; und
die Elektrode (120, 120a, 130, 140, 240, 250, 340, 350, 360) eine zweidimensionale Oberfläche zum Auffangen der von der Kathode (110, 210, 220, 310, 320, 330) emittierten Elektronen umfasst, und die zweidimensionale Oberfläche eine zu einer Oberflächennormale erste orthogonale Ausdehnung und eine zweite orthogonale Ausdehnung besitzt, wobei die erste orthogonale Ausdehnung senkrecht zu der zweiten orthogonalen Ausdehnung verläuft, wobei ein Längenverhältnis der ersten orthogonalen Ausdehnung zu der zweiten orthogonalen Ausdehnung zwischen 0,4 und 1 liegt.

2. Vakuumkammer nach Anspruch 1, wobei das Längenverhältnis der ersten orthogonalen Ausdehnung zu der zweiten orthogonalen Ausdehnung bei 1 liegt und / oder die zweidimensionale Oberfläche im Bereich zwischen 5 bis 2000 cm², insbesondere 25 bis 320 cm² liegt und / oder die Elektrode (120, 120a, 130, 140, 240, 250, 340, 350, 360) zumindest teilweise in der Kammerwand angeordnet ist.

3. Vakuumkammer nach einem der vorrangehenden Ansprüche, wobei die zweidimensionale Oberfläche eine Strukturierung aufweist, wobei ein Verhältnis einer maximalen Tiefe der Strukturierung und einer kleineren orthogonalen Ausdehnung der zweidimensionalen Oberfläche der Elektrode (120, 120a, 130, 140, 240, 250, 340, 350, 360) maximal 0,4 beträgt und / oder die zweidimensionale Oberfläche der Elektrode (120, 120a, 130, 140, 240, 250, 340, 350, 360) eckig, rund oder ellipsoidisch ist.

4. Vakuumkammer nach einem der vorrangehenden Ansprüche, wobei die Elektrode (120, 120a, 130, 140, 240, 250, 340, 350, 360) an einer die Kathode (110, 210, 220, 310, 320, 330) umfassenden Kammerwand oder an einer anderen Kammerwand vorgesehen ist, wobei der Abstand zwischen der Kathode (110, 210, 220, 310, 320, 330) und der Elektrode (120, 120a, 130, 140, 240, 250, 340, 350, 360) in einem Bereich zwischen 1cm bis 200 cm, bevorzugt 5 bis 150 cm, insbesondere 10 bis 100 cm liegt.

5. Vakuumkammer nach einem der vorrangehenden Ansprüche, wobei eine Stromdichte der Elektrode (120, 120a, 130, 140, 240, 250, 340, 350, 360) zwischen 0,1 bis 5 A/cm², insbesondere zwischen 0,1 bis 4 A/cm², im speziellen zwischen 0,2 bis 2 A/cm² liegt und / oder eine Spannung der Elektrode (120, 120a, 130, 140, 240, 250, 340, 350, 360) zwischen 5 bis 100 V, insbesondere zwischen 10 bis 100 V, im speziellen zwischen 20 bis 60 V liegt und / oder eine Leistungsdichte der Elektrode (120, 120a, 130, 140, 240, 250, 340, 350, 360) zwischen 0,25 bis 500 W/cm², insbesondere zwischen 1 bis 400 W/cm², im speziellen zwischen 4 bis 120 W/cm² liegt und /oder ein Strom der Elektrode (120, 120a, 130, 140, 240, 250, 340, 350, 360) einer Fläche von ungefähr 80 cm² zwischen 5 bis 400 A, insbesondere zwischen 10 bis 300 A, im speziellen zwischen 20 bis 200 A, besonders bevorzugt zwischen 10 und 150 A liegt.

6. Vakuumkammer nach einem der vorrangehenden Ansprüche, wobei die Elektrode als Beschichtungsquelle ausgestaltet ist und derart mit einem Netzteil (121, 241, 341, 131, 251, 351) verbindbar ist, dass die Beschichtungsquelle als eine Plasmaelektrode verwendet werden kann.

7. Vakuumkammer nach einem der vorrangehenden Ansprüche umfassend eine Vielzahl von Elektroden (120, 120a, 130, 140, 240, 250, 340, 350, 360) und /oder eine Vielzahl von Kathoden (110, 210, 220, 310, 320, 330), insbesondere zwei Elektroden (120, 120a, 130, 140, 240, 250, 340, 350, 360) und zwei Kathoden (110, 210, 220, 310, 320, 330), im speziellen drei Elektroden (120, 120a, 130, 140, 240, 250, 340, 350, 360) und drei Kathoden (110, 210, 220, 310, 320, 330).

8. Vakuumkammer nach Anspruch 7 umfassend eine gleiche Anzahl von Elektroden (120, 120a, 130, 140, 240, 250, 340, 350, 360) und Kathoden oder umfassend eine grössere Anzahl von Elektroden (120, 120a, 130, 140, 240, 250, 340, 350, 360) als Kathoden, insbesondere zwei Elektroden (120, 120a, 130, 140, 240, 250, 340, 350, 360) und die eine einzige Kathode, im speziellen drei Elektroden (120, 120a, 130, 140, 240, 250, 340, 350, 360) und die eine einzige Kathode oder umfassend eine grössere Anzahl von Kathoden (110, 210, 220, 310, 320, 330) als Elektroden (120, 120a, 130, 140, 240, 250, 340, 350, 360), insbesondere zwei Kathoden (110, 210, 220, 310, 320, 330) und die eine einzige Elektrode (120, 120a, 130, 140, 240, 250, 340, 350, 360), im speziellen drei Kathoden (110, 210, 220, 310, 320, 330) und die eine einzige Elektrode (120, 120a, 130, 140, 240, 250, 340, 350, 360).

9. Vakuumkammer nach einem der vorrangehenden Ansprüche, wobei ein die Arbeitsoberfläche bildender Teil der Elektrode (120, 120a, 130, 140, 240, 250, 340, 350, 360) ein gekühlter Teil der Elektrode, insbesondere ein wassergekühlter Teil der Elektrode ist, und der gekühlte Teil der Elektrode, insbesondere direkt kühlbar ist oder auf einem Kühlkörper angeordnet ist.

10. Vakuumkammer nach einem der vorrangehenden Ansprüche, wobei die Elektrode (120, 120a, 130, 140, 240, 250, 340, 350, 360) Graphit, eine Legierung aus Kupferkohlenstoff, Stahl, Kupfer, eine Kupferlegierung, Aluminium oder eine Aluminiumlegierung umfasst und / oder die Kathode Titan, eine Titanlegierungen, Zirkonium, eine Zirkoniumlegierungen, Aluminium, eine Aluminiumlegierungen oder Sauerstoff-getternde Materialien umfasst.

## Claims

1. A vacuum chamber for performing a plasma treatment comprising a plasma treatment area which is enclosed by chamber walls, and a plasma source comprising:
a cathode (110, 210, 220, 310, 320, 330) for cathodic vacuum arc evaporation with an arc anode which is connected to the chamber, wherein the cathode is arranged in the chamber on the chamber wall;
an electrode (120, 120a, 130, 140, 240, 250, 340, 350, 360) arranged in the chamber and spaced from the cathode (110, 210, 220, 310, 320, 330) for controlling a plasma in the vacuum chamber;
**characterized in that**
the plasma source further comprises:
a shield (115, 230, 332, 333, 334) for shielding particles and metal ions which are emitted from the cathode, wherein the shield (115, 230, 332, 333, 334) is provided in the vacuum chamber in such a way that it can be arranged in front of the cathode (110, 210, 220, 310, 320, 330); and
the electrode (120, 120a, 130, 140, 240, 250, 340, 350, 360) comprises a two-dimensional surface for collecting electrons emitted from the cathode (110, 210, 220, 310, 320, 330), and the two-dimensional surface has a first orthogonal extension and a second orthogonal extension to a surface normal, wherein the first orthogonal extension is perpendicular to the second orthogonal extension, wherein a length ratio of the first orthogonal extension to the second orthogonal extension is between 0.4 and 1.

2. A vacuum chamber according to claim 1, wherein the length ratio of the first orthogonal extension to the second orthogonal extension is 1 and / or the two-dimensional surface is in the range between 5 to 2000 cm², in particular 25 to 320 cm², and / or the electrode (120, 120a, 130, 140, 240, 250, 340, 350, 360) is arranged at least partially in the chamber wall.

3. A vacuum chamber according to anyone of the preceding claims, wherein the two-dimensional surface has a structuring, wherein a ratio of a maximum depth of the structuring and a smaller orthogonal extension of the two-dimensional surface of the electrode (120, 120a, 130, 140, 240, 250, 340, 350, 360) is at most 0.4, and / or the two-dimensional surface of the electrode (120, 120a, 130, 140, 240, 250, 340, 350, 360) is angular, round or ellipsoidal.

4. A vacuum chamber according to anyone of the preceding claims, wherein the electrode (120, 120a, 130, 140, 240, 250, 340, 350, 360) is provided on a chamber wall comprising the cathode (110, 210, 220, 310, 320, 330) or on another chamber wall, wherein the distance between the cathode (110, 210, 220, 310, 320, 330) and the electrode (120, 120a, 130, 140, 240, 250, 340, 350, 360) is in a range between 1cm to 200 cm, preferably 5 to 150 cm, in particular 10 to 100 cm.

5. A vacuum chamber according to anyone of the preceding claims, wherein a current density of the electrode (120, 120a, 130, 140, 240, 250, 340, 350, 360) is between 0.1 to 5 A/cm², in particular between 0.1 to 4 A/cm², especially between 0.2 to 2 A/cm² and / or a voltage of the electrode (120, 120a, 130, 140, 240, 250, 340, 350, 360) is between 5 to 100 V, in particular between 10 to 100 V, especially between 20 to 60 V and / or a power density of the electrode (120, 120a, 130, 140, 240, 250, 340, 350, 360) is between 0.25 to 500 W/cm², in particular between 1 to 400 W/cm², especially between 4 to 120 W/cm², and / or a current of the electrode (120, 120a, 130, 140, 240, 250, 340, 350, 360) of an area of about 80 cm² is between 5 to 400 A, in particular between 10 to 300 A, especially between 20 to 200 A, particularly preferably between 10 and 150 A.

6. A vacuum chamber according to anyone of the preceding claims, wherein the electrode is designed as a coating source and can be connected to a power supply (121, 241, 341, 131, 251, 351) in such a way that the coating source can be used as a plasma electrode.

7. A vacuum chamber according to anyone of the preceding claims comprising a plurality of electrodes (120, 120a, 130, 140, 240, 250, 340, 350, 360) and / or a plurality of cathodes (110, 210, 220, 310, 320, 330), in particular two electrodes (120, 120a, 130, 140, 240, 250, 340, 350, 360) and two cathodes (110, 210, 220, 310, 320, 330), especially three electrodes (120, 120a, 130, 140, 240, 250, 340, 350, 360) and three cathodes (110, 210, 220, 310, 320, 330).

8. A vacuum chamber according to claim 7 comprising an equal number of electrodes (120, 120a, 130, 140, 240, 250, 340, 350, 360) and cathodes or comprising a larger number of electrodes (120, 120a, 130, 140, 240, 250, 340, 350, 360) than cathodes, in particular two electrodes (120, 120a, 130, 140, 240, 250, 340, 350, 360) and the one single cathode, especially three electrodes (120, 120a, 130, 140, 240, 250, 340, 350, 360) and the one single cathode or comprising a larger number of cathodes (110, 210, 220, 310, 320, 330) than electrodes (120, 120a, 130, 140, 240, 250, 340, 350, 360), in particular two cathodes (110, 210, 220, 310, 320, 330) and the one single electrode (120, 120a, 130, 140, 240, 250, 340, 350, 360), especially three cathodes (110, 210, 220, 310, 320, 330) and the one single electrode (120, 120a, 130, 140, 240, 250, 340, 350, 360).

9. A vacuum chamber according to anyone of the preceding claims, wherein a part of the electrode (120, 120a, 130, 140, 240, 250, 340, 350, 360) forming the working surface is a cooled part of the electrode, in particular a water-cooled part of the electrode, and the cooled part of the electrode can in particular be cooled directly or is arranged on a cooling body.

10. A vacuum chamber according to anyone of the preceding claims, wherein the electrode (120, 120a, 130, 140, 240, 250, 340, 350, 360) comprises graphite, an alloy of copper carbon, steel, copper, a copper alloy, aluminum, or an aluminum alloy and / or the cathode comprises titanium, a titanium alloy, zirconium, a zirconium alloy, aluminum, an aluminum alloy, or oxygen-gettering materials.

## Revendications

1. Chambre à vide pour effectuer un traitement au plasma comprenant une zone de traitement au plasma entourée par des parois de chambre, et une source de plasma comprenant :
une cathode (110, 210, 220, 310, 320, 330) pour une évaporation par arc sous vide cathodique avec une anode à arc reliée à la chambre, la cathode étant disposée dans la chambre au niveau de la paroi de chambre ;
une électrode (120, 120a, 130, 140, 240, 250, 340, 350, 360) disposée dans la chambre et espacée de la cathode (110, 210, 220, 310, 320, 330) pour commander un plasma dans la chambre à vide ;
**caractérisée en ce que**
la source de plasma comprend en outre :
un blindage (115, 230, 332, 333, 334) pour le blindage des particules et des ions métalliques émis par la cathode, le blindage (115, 230, 332, 333, 334) étant prévu dans la chambre à vide de manière à pouvoir être disposé devant la cathode (110, 210, 220, 310, 320, 330) ; et
l'électrode (120, 120a, 130, 140, 240, 250, 340, 350, 360) comprend une surface bidimensionnelle pour collecter les électrons émis par la cathode (110, 210, 220, 310, 320, 330), et la surface bidimensionnelle a une première extension orthogonale à une normale de surface et une deuxième extension orthogonale, la première extension orthogonale étant perpendiculaire à la deuxième extension orthogonale, un rapport de longueur de la première extension orthogonale à la deuxième extension orthogonale étant compris entre 0,4 et 1.

2. Chambre à vide selon la revendication 1, dans laquelle le rapport de longueur de la première extension orthogonale à la deuxième extension orthogonale est de 1 et/ou la surface bidimensionnelle est comprise entre 5 et 2000 cm², en particulier entre 25 et 320 cm² , et/ou l'électrode (120, 120a, 130, 140, 240, 250, 340, 350, 360) est disposée au moins partiellement dans la paroi de chambre.

3. Chambre à vide selon l'une quelconque des revendications précédentes, dans laquelle la surface bidimensionnelle présente une structuration, un rapport d'une profondeur maximale de la structuration et d'une plus petite extension orthogonale de la surface bidimensionnelle de l'électrode (120, 120a, 130, 140, 240, 250, 340, 350, 360) étant au maximum de 0,4 et/ou la surface bidimensionnelle de l'électrode (120, 120a, 130, 140, 240, 250, 340, 350, 360) étant angulaire, ronde ou ellipsoïdale.

4. Chambre à vide selon l'une quelconque des revendications précédentes, dans laquelle l'électrode (120, 120a, 130, 140, 240, 250, 340, 350, 360) est prévue au niveau d'une paroi de chambre comprenant la cathode (110, 210, 220, 310, 320, 330) ou au niveau d'une autre paroi de chambre, la distance entre la cathode (110, 210, 220, 310, 320, 330) et l'électrode (120, 120a, 130, 140, 240, 250, 340, 350, 360) étant comprise entre 1 cm et 200 cm, de préférence entre 5 et 150 cm, en particulier entre 10 et 100 cm.

5. Chambre à vide selon l'une quelconque des revendications précédentes, dans laquelle une densité de courant de l'électrode (120, 120a, 130, 140, 240, 250, 340, 350, 360) est comprise entre 0,1 et 5 A/cm² , en particulier entre 0,1 et 4 A/cm² , en particulier entre 0,2 et 2 A/cm² et/ou une tension de l'électrode (120, 120a, 130, 140, 240, 250, 340, 350, 360) est comprise entre 5 et 100 V, en particulier entre 10 et 100 V, en particulier entre 20 et 60 V et/ou une densité de puissance de l'électrode (120, 120a, 130, 140, 240, 250, 340, 350, 360) est comprise entre 0,25 et 500 W/cm² , en particulier entre 1 et 400 W/cm² , en particulier entre 4 et 120 W/cm² et/ou un courant de l'électrode (120, 120a, 130, 140, 240, 250, 340, 350, 360) d'une surface d'environ 80 cm² est comprise entre 5 et 400 A, en particulier entre 10 et 300 A, en particulier entre 20 et 200 A, de manière particulièrement préférée entre 10 et 150 A.

6. Chambre à vide selon l'une quelconque des revendications précédentes, dans laquelle l'électrode est conçue comme une source de revêtement et peut être reliée à une alimentation (121, 241, 341, 131, 251, 351) de manière à ce que la source de revêtement peut être utilisée comme une électrode à plasma.

7. Chambre à vide selon l'une quelconque des revendications précédentes, comprenant une pluralité d'électrodes (120, 120a, 130, 140, 240, 250, 340, 350, 360) et/ou une pluralité de cathodes (110, 210, 220, 310, 320, 330), en particulier deux électrodes (120, 120a, 130, 140, 240, 250, 340, 350, 360) et deux cathodes (110, 210, 220, 310, 320, 330), en particulier trois électrodes (120, 120a, 130, 140, 240, 250, 340, 350, 360) et trois cathodes (110, 210, 220, 310, 320, 330).

8. Chambre à vide selon la revendication 7, comprenant un même nombre d'électrodes (120, 120a, 130, 140, 240, 250, 340, 350, 360) et de cathodes ou comprenant un plus grand nombre d'électrodes (120, 120a, 130, 140, 240, 250, 340, 350, 360) que de cathodes, en particulier deux électrodes (120, 120a, 130, 140, 240, 250, 340, 350, 360) et ladite une seule cathode, en particulier trois électrodes (120, 120a, 130, 140, 240, 250, 340, 350, 360) et ladite une seule cathode ou comprenant un plus grand nombre de cathodes (110, 210, 220, 310, 320, 330) que d'électrodes (120, 120a, 130, 140, 240, 250, 340, 350, 360), en particulier deux cathodes (110, 210, 220, 310, 320, 330) et ladite une seule électrode (120, 120a, 130, 140, 240, 250, 340, 350, 360), en particulier trois cathodes (110, 210, 220, 310, 320, 330) et ladite une seule électrode (120, 120a, 130, 140, 240, 250, 340, 350, 360).

9. Chambre à vide selon l'une quelconque des revendications précédentes, dans laquelle une partie de l'électrode (120, 120a, 130, 140, 240, 250, 340, 350, 360) formant la surface de travail est une partie refroidie de l'électrode, en particulier une partie refroidie à l'eau de l'électrode, et la partie refroidie de l'électrode peut être refroidie en particulier directement ou est disposée sur un corps de refroidissement.

10. Chambre à vide selon l'une quelconque des revendications précédentes, dans laquelle l'électrode (120, 120a, 130, 140, 240, 250, 340, 350, 360) comprend du graphite, un alliage de cuivre-carbone, de l'acier, du cuivre, un alliage de cuivre, de l'aluminium ou un alliage d'aluminium et/ou la cathode comprend du titane, un alliage de titane, du zirconium, un alliage de zirconium, de l'aluminium, un alliage d'aluminium ou des matériaux absorbant l'oxygène.
